# EUROPEAN PATENT APPLICATION

(11) **EP 1 881 701 A1**
(43) Date of publication of application: **23.01.2008**
(21) Application number: 07107242.5
(22) Date of filing: 30.04.2007
(51) Int. Cl.: H04N 5/50, H03J 1/00, H04H 1/00

(54) **Broadcasting receiving apparatus for providing a fixed channel, and method therefor**

(30) Priority: 20.07.2006 KR 20060068109
(71) Applicant: Samsung Electronics Co., Ltd., Suwon-si 442-742 Gyeonggi-do (KR)
(72) Inventor: Han, Jea-hee, Gyeonggi-do (KR)
(74) Representative: Perkins, Dawn Elizabeth

(57) **Abstract**

Disclosed are a broadcasting receiving apparatus for providing a fixed channel and a method therefor. The broadcasting receiving apparatus includes: a storing unit for storing one or more channels mapped in corresponding channel frequencies, respectively; and a control unit for, when the stored channel is changed, re-mapping a channel frequency of the changed channel in the channel stored in the storing unit, and storing the channel frequency. Even if any channel is arbitrarily changed by a system operator, the fixed channel is provided to a user in the storing order.

## Description

The present invention relates to a broadcasting receiving apparatus for providing a fixed channel and a method therefor. More particularly, the present invention relates to a broadcasting receiving apparatus for providing a fixed channel and a method therefor which can provide a fixed channel to a user by fixing a channel frequently changed by a cable television system operator.

With the recent expansion of pay broadcasting such as cable television, system operators change channels based on program profitability.

The channels initially set by the user through auto search are frequently changed. Accordingly, the user must reset the changed channels one by one, which causes inconvenience and confusion.

Embodiments of the present invention have been developed in order to substantially address the above and other-problems associated with the conventional arrangement. An aspect of embodiments of the present invention is to provide a fixed channel and a method therefor which can fix a channel changed by a system operator to a channel set by a user to reduce inconvenience and confusion of the user and guarantee variety of broadcasting.

In order to achieve the above-described aspect of the invention, there is provided a broadcasting receiving apparatus, including: a storing unit which stores one or more channels mapped in corresponding channel frequencies, respectively; and a control unit which, when the stored channel is changed, re-maps a channel frequency of the changed channel in the channel stored in the storing unit, and stores the channel frequency.

The storing unit may further store channel IDs including channel information of each channel, the channel IDs being mapped in the one or more channels. The control unit decides channel change or non-change by comparing the channel ID of the changed channel with the channel IDs of the channels stored in the storing unit.

The broadcasting receiving apparatus may further include: a first tuner unit which receives a broadcasting signal corresponding to a channel selected by a user command among the channels stored in the storing unit; and a second tuner unit which performs auto search under the control of the control unit, while the first tuner unit receives the broadcasting signal corresponding to the selected channel.

The broadcasting receiving apparatus may further include a tuner unit which performs auto search in a standby mode under the control of the control unit. The broadcasting receiving apparatus may further include a power supply unit which supplies power to the tuner unit in the standby mode.

In addition, there is provided a method for providing a fixed channel in a broadcasting receiving apparatus, including: storing one or more channels mapped in corresponding channel frequencies, respectively; deciding change or non-change of the stored channels; and re-mapping a channel frequency of a changed channel in the stored channel, and storing the channel frequency.

The method for providing the fixed channel may further include storing channel IDs including channel information of each channel, the channel IDs being mapped in the one or more channels. The deciding the change or non-change of the stored channels decides the channel change or non-change by comparing the channel ID of the changed channel with the channel IDs of the stored channels.

The method for providing the fixed channel may further include: receiving a broadcasting signal corresponding to a channel selected by a user command among the stored channels; and while the broadcasting signal corresponding to the selected channel is received, performing auto search.

The deciding the change or non-change of the stored channels may decide the change or non-change of the stored channels by performing auto search in a standby mode.

The above aspects and features of embodiments of the present invention will become more apparent by describing certain exemplary embodiments of the present invention with reference to the accompanying drawings, in which:
Figure 1 is a schematic block diagram illustrating an exemplary broadcasting receiving apparatus in accordance with a first embodiment of the present invention;
Figure 2 is an exemplary diagram illustrating channel auto search of a second tuner unit of the broadcasting receiving apparatus in accordance with the first embodiment of the present invention;
Figure 3 is a flowchart showing sequential steps of an exemplary method for providing a fixed channel in the broadcasting receiving apparatus in accordance with the first embodiment of the present invention; and
Figure 4 is a schematic block diagram illustrating an exemplary broadcasting receiving apparatus in accordance with a second embodiment of the present invention.

A broadcasting receiving apparatus for providing a fixed channel and a method therefor in accordance with preferred embodiments of the present invention will now be described in detail with reference to the accompanying drawings. Also, well-known functions or constructions are not described in detail since that would obscure the invention in unnecessary detail.

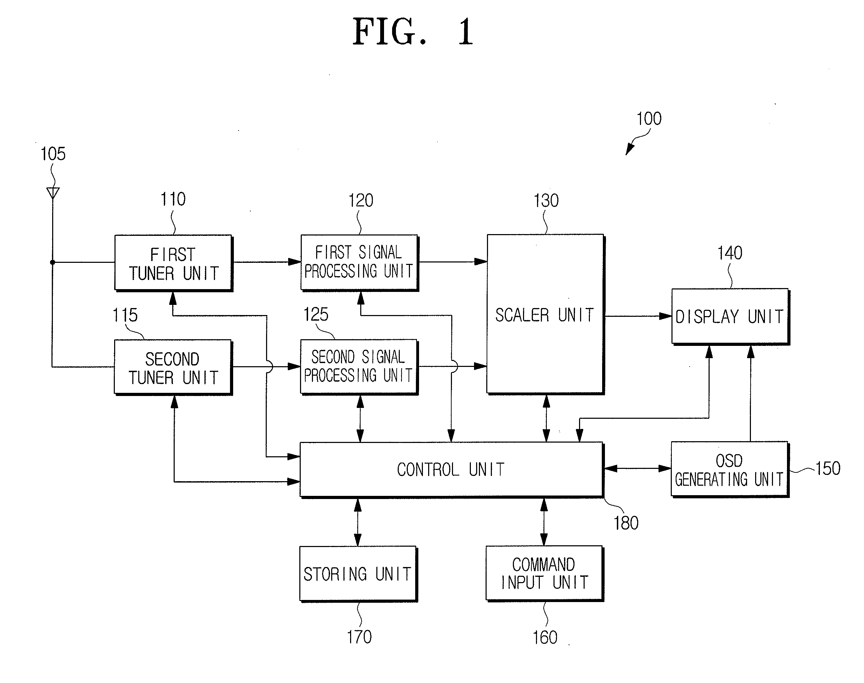

Figure 1 is a schematic block diagram illustrating a broadcasting receiving apparatus in accordance with a first embodiment of the present invention.

Referring to Figure 1, the broadcasting receiving apparatus 100 includes an antenna 105, a first tuner unit 110, a second tuner unit 115, a first signal processing unit 120, a second signal processing unit 125, a scaler unit 130, a display unit 140, an On Screen Display (OSD) generating unit 150, a command input unit 160, a storing unit 170 and a control unit 180.

The first tuner unit 110 receives a broadcasting signal corresponding to a channel selected by the user through the antenna 105 under the control of the control unit 180 discussed later. The received broadcasting signal is processed by the first signal processing unit 120, and output as an image signal and a sound signal. The sound signal is output through a speaker (not shown) and the image signal is transmitted to the scaler unit 130.

In the case that a Picture-In-Picture (PIP) operation is performed, the second tuner unit 115 receives the broadcasting signal corresponding to the channel selected by the user through the antenna 105 under the control of the control unit 180. The received broadcasting signal is processed by the second signal processing unit 125, and transmitted to the scaler unit 130 as an image signal for generating a PIP screen.

Conversely, when the PIP operation is not performed, the second tuner unit 115 performs auto search under the control of the control unit 180, and the control unit 180 decides whether or not to change the searched channels. That is, the second tuner unit 115 performs auto search for the channels stored in the storing unit 170 discussed later. If the control unit 180 decides a channel change, the second tuner unit 115 performs auto search for all the channels.

In the case that the PIP operation is not performed, the scaler unit 130 scales only the image signal from the first signal processing unit 120 and outputs the resulting signal. Conversely, when the PIP operation is performed, the scaler unit 130 scales the image signal from the second signal processing unit 125, generates a PIP image, inserts the PIP image into the image signal from the first signal processing unit 120, and outputs the resulting signal.

The display unit 140 displays the image signal scaled by the scaler unit 130 on a screen. In addition, the display unit 140 displays OSD menus generated by the OSD generating unit 150 discussed later on the screen under the control of the control unit 180.

The OSD generating unit 150 generates the OSD menu for enabling the user to control the operation of the broadcasting receiving apparatus 100 and the OSD menu for notifying the operation state of the broadcasting receiving apparatus 100, and outputs the OSD menus to the display unit 140 under the control of the control unit 180.

The command input unit 160 transmits a user command inputted through a remote controller (not shown) or various operation keys (not shown) to the control unit 180. The user inputs a searching command for performing initial auto search, and a setting command for mapping the channels in channel frequencies and channel IDs including information of each channel and storing the channels in the storing unit 170 to the broadcasting receiving apparatus 100 through the command input unit 160.

The storing unit 170 stores the channels mapped by the setting command of the user. That is, after the initial auto search is performed by the searching command of the user, the channels selected by the user among the available channels, the channel frequencies corresponding to the selected channels, and the channel IDs are mapped and stored as shown in Table 1.

**Table 1**

| **Channel** | **Channel frequency (MHz)** | **Channel ID** |
|---|---|---|
| 6 | 82~88 | SBS |
| 7 | 174~180 | KBS |
| 9 | 186~192 | YTN |
| 11 | 198~204 | MBC |
| : | : | : |

When the PIP operation is not performed, the control unit 180 controls the second tuner unit 115 to perform the auto search for the channels stored in the storing unit 170. That is, the control unit 180 receives the channel IDs included in the broadcasting signals corresponding to Channels 6, 7, 9, 11, ... from the second tuner unit 115. The control unit 180 decides whether any channel has been changed, by comparing the channel IDs of each channel with the channel IDs of the channels stored in the storing unit 170.

When the channel ID of the stored channel does not exist in the channel IDs of the searched channels, the control unit 180 decides that the corresponding channel has been changed, and controls the second tuner unit 115 to perform the auto search for all the channels. When the channel ID of the changed channel exists among the channel IDs of all the channels searched by the second tuner unit 115, the control unit 180 re-maps the corresponding channel and stores the channel in the storing unit 170.

Thereafter, when the user inputs a channel select command, the control unit 180 reads the channel frequency corresponding to the channel selected by the user from the storing unit 170, and receives the broadcasting signal corresponding to the selected channel from the first tuner unit 110.

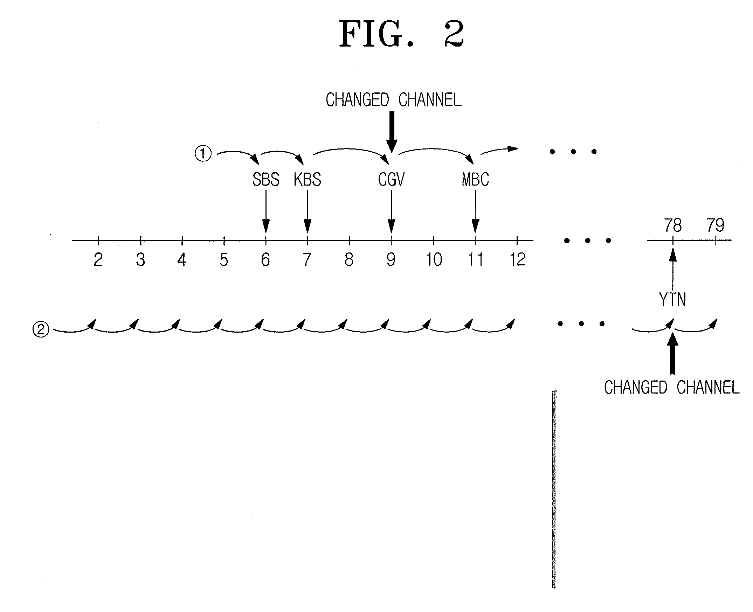

The operation of the control unit 180 will now be described in more detail with reference to Table 1 and Figure 2.

Figure 2 is an exemplary diagram illustrating the channel auto search of the second tuner unit of the broadcasting receiving apparatus in accordance with the first embodiment of the present invention.

In Figure 2, the mapped channel 9 has been changed from YTN to CGV by the cable television system operator.

If the PIP operation is not performed, the control unit 180 controls the second tuner unit 115 to perform the auto search for the mapped channels 6, 7, 9, 11, ... stored in the storing unit 170 (shown by ①). Here, the control unit 180 receives the channel IDs corresponding to the stored channels from the second tuner unit 115, and compares the received channel IDs with the channel IDs of the channels stored in the storing unit 170. According to the comparison result, the control unit decides that the channel ID of the stored channel 9 is not YTN, and determines a change in Channel 9.

After deciding the channel change, the control unit 180 controls the second tuner unit 115 to perform the auto search for all the whole channels (shown by ②). While the auto search is performed, if the control unit 180 receives Channel 78 having the channel ID of YTN, the control unit 180 re-maps a channel frequency corresponding to Channel 78 in Channel 9, and stores the channel frequency in the storing unit 170 as shown in Table 2.

**Table 2**

| **Channel** | **Channel frequency (MHz)** | **Channel ID** |
|---|---|---|
| 6 | 82~88 | SBS |
| 7 | 174~180 | KBS |
| 9 | 546~552 | YTN |
| 11 | 198~204 | MBC |
| : | : | : |

When the user selects Channel 9, the control unit 180 reads the channel frequency corresponding to Channel 9 from the storing unit 170, and receives the broadcasting signal corresponding to the selected channel from the first tuner unit 110.

The channel change has been exemplified in Figure 2. Even if no broadcasting signal is received in Channel 9, the changed channel is re-mapped by the channel auto search as described above.

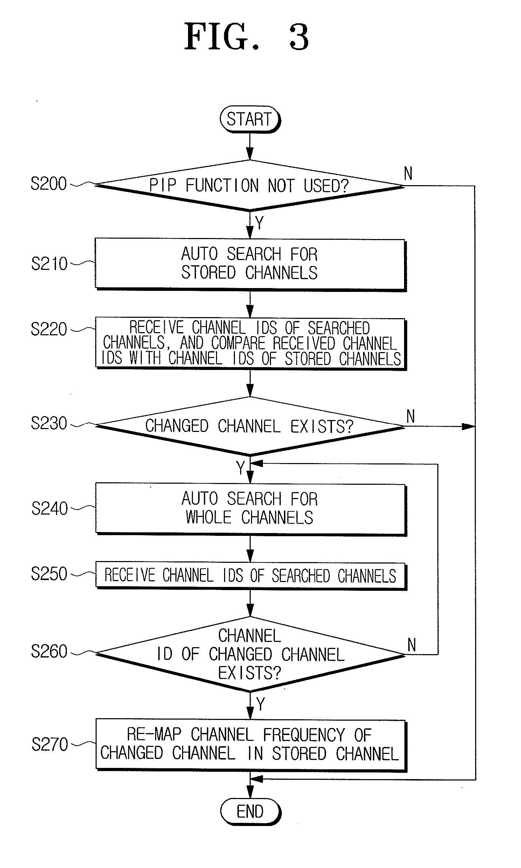

Figure 3 is a flowchart showing sequential steps of a method for providing a fixed channel in the broadcasting receiving apparatus in accordance with the first embodiment of the present invention.

As shown in Figure 3, when the broadcasting receiving apparatus 100 does not perform the PIP function (S200), the auto search for the stored channels is carried out (S210). That is, the control unit 180 controls the second tuner unit 115 to perform the auto search for the channels stored in the storing unit 170.

The control unit 180 receives the channel IDs of the searched channels from the second tuner unit 115, and compares the received channel IDs with the channel IDs of the channels stored in the storing unit 170 (S220).

When the control unit 180 decides that a channel has been changed (S230), the auto search for all the channels is carried out (S240). When the channel ID of the stored channel does not exist in the channel IDs of the searched channels, the control unit 180 decides that the corresponding channel has been changed, and controls the second tuner unit 115 to perform the auto search for all the channels.

The control unit 180 receives the channel IDs of the searched channels from the second tuner unit 115 (S250). When the channel ID of the changed channel exists in the received channel IDs (S260), the control unit 180 re-maps a channel frequency of the changed channel in the stored channel (S270). That is, the second tuner unit 115 starts the auto search from the first channel under the control of the control unit 180, and receives the channel IDs of each channel. When the channel ID of the changed channel exists in the received channel IDs, the control unit 180 re-maps the channel frequency of the changed channel in the stored channel.

By the above procedure, the changed channels are sensed and re-mapped in the stored channels, so that the fixed channels can be provided to the user. Therefor, the user can use the fixed channels in the storing order.

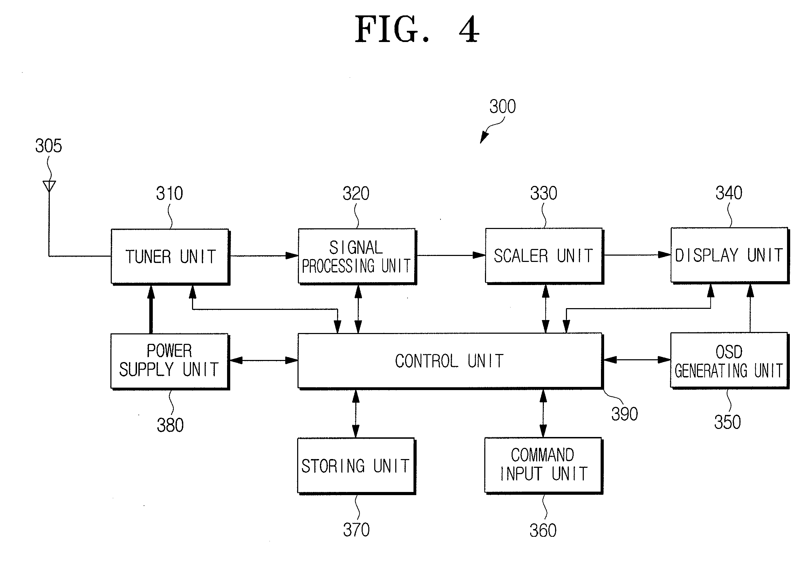

Figure 4 is a schematic block diagram illustrating a broadcasting receiving apparatus in accordance with a second embodiment of the present invention.

As illustrated in Figure 4, the broadcasting receiving apparatus 300 includes an antenna 305, a tuner unit 310, a signal processing unit 320, a scaler unit 330, a display unit 340, an OSD generating unit 350, a command input unit 360, a storing unit 370, a power supply unit 380 and a control unit 390.

The tuner unit 310 receives a broadcasting signal corresponding to a channel selected by the user through the antenna 305 under the control of the control unit 390. The received broadcasting signal is processed by the signal processing unit 320, and outputted as an image signal and a sound signal. The sound signal is output through a speaker (not shown) and the image signal is transmitted to the scaler unit 330.

If the user does not watch a broadcast through the broadcasting receiving apparatus 300, for example, if the broadcasting receiving apparatus 300 is in a standby mode, the tuner unit 310 performs auto search under the control of the control unit 390, and the control unit 390 decides whether or not a channel changed by searching the channels. That is, the tuner unit 310 performs auto search for the channels stored in the storing unit 370 discussed later. If the control unit 390 decides that a channel has changed, the tuner unit 310 performs auto search for all the channels.

The scaler unit 330 scales the image signal from the signal processing unit 320 and outputs the resulting signal. The display unit 340 displays the image signal scaled by the scaler unit 330 on a screen. In addition, the display unit 340 displays OSD menus generated by the OSD generating unit 350 discussed later on the screen under the control of the control unit 390.

The OSD generating unit 350 generates the OSD menu for enabling the user to control the operation of the broadcasting receiving apparatus 300 and the OSD menu for notifying the operation state of the broadcasting receiving apparatus 300, and outputs the OSD menus to the display unit 340 under the control of the control unit 390.

The command input unit 360 transmits a user command inputted through a remote controller (not shown) or various operation keys (not shown) to the control unit 390. The user inputs a searching command for performing initial auto search, and a setting command for mapping the channels in channel frequencies and channel IDs including information of each channel and storing the channels in the storing unit 370 to the broadcasting receiving apparatus 300 through the command input unit 360.

The storing unit 370 stores the channels mapped by the setting command of the user. That is, after the initial auto search is performed by the searching command of the user, the channels selected by the user among the available channels, the channel frequencies corresponding to the selected channels, and the channel IDs are mapped and stored as shown in Table 1.

When the broadcasting receiving apparatus 300 is in the standby mode, the power supply unit 380 supplies power to the tuner unit 310 under the control of the control unit 390.

If the broadcasting receiving apparatus 300 is in standby mode, the control unit 390 controls the tuner unit 310 to perform the auto search for the channels stored in the storing unit 370. That is, the control unit 390 receives the channel IDs included in the broadcasting signals corresponding to Channels 6, 7, 9, 11, ... from the tuner unit 310. The control unit 390 decides whether any channel has been changed, by comparing the channel IDs of each channel with the channel IDs of the channels stored in the storing unit 370.

When the channel ID of the stored channel does not exist among the channel IDs of the searched channels, the control unit 390 decides that the corresponding channel has been changed, and controls the tuner unit 310 to perform the auto search for all the channels. When the channel ID of the changed channel exists among the channel IDs of all the channels searched by the tuner unit 310, the control unit 390 re-maps the corresponding channel and stores the channel in the storing unit 370.

Thereafter, when the user inputs a channel select command, the control unit 390 reads the channel frequency corresponding to the channel selected by the user from the storing unit 370, and receives the broadcasting signal corresponding to the selected channel from the tuner unit 310.

A method for providing a fixed channel in the broadcasting receiving apparatus 300 of Figure 4 is identical to the above operations S210 to S270 after the operation of deciding whether the broadcasting receiving apparatus 300 is in the standby mode. Thus, detailed explanations thereof are omitted.

As discussed earlier, in accordance with the present invention, even if a predetermined broadcast channel is arbitrarily changed, the fixed channel is provided to the user. Therefor, the user does not have to reset the channels one by one. As a result, the user can conveniently use the channels, and various broadcasts can be tailored for each of the users.

The foregoing embodiment and advantages are merely exemplary and are not to be construed as limiting the present invention. The present teaching can be readily applied to other types of apparatuses. Also, the description of the embodiments of the present invention is intended to be illustrative, and not to limit the scope of the claims, and many alternatives, modifications, and variations falling within the scope of the claims will be apparent to those skilled in the art.

## Claims

1. A broadcasting receiving apparatus, comprising:
a storing unit (170, 370) which stores one or more channels mapped to corresponding channel frequencies, respectively; and
a control unit (180, 390) configured to, when the stored channel is changed, re-map a channel frequency of the changed channel to the channel stored in the storing unit, and store the channel frequency.

2. The broadcasting receiving apparatus as claimed in claim 1, wherein the storing unit (170, 370) further stores channel IDs including channel information of each channel, the channel IDs being mapped in the one or more channels.

3. The broadcasting receiving apparatus as claimed in claim 2, wherein the control unit (180, 390) is configured to decide whether or not a channel has changed by comparing the channel ID of a channel with the channel IDs of the channels stored in the storing unit (170, 370).

4. The broadcasting receiving apparatus as claimed in any one of the preceding claims, further comprising:
a first tuner unit (110) configured to receive a broadcasting signal corresponding to a channel selected by a user command among the channels stored in the storing unit (170); and
a second tuner unit (115) configured to perform an auto search under control of the control unit (180), while the first tuner unit (110) receives the broadcasting signal corresponding to the selected channel.

5. The broadcasting receiving apparatus as claimed in claim 1, 2 or 3 further comprising a tuner unit (310) configured to perform auto search in a standby mode under control of the control unit (390).

6. The broadcasting receiving apparatus as claimed in claim 5, further comprising a power supply unit (380) configured to supply power to the tuner unit (310) in standby mode.

7. A method for providing a fixed channel, comprising:
storing one or more channels mapped to corresponding channel frequencies, respectively;
deciding whether or not there is a change in the stored channels; and
re-mapping a channel frequency of the changed channel to the stored channel, and storing the channel frequency.

8. The method for providing the fixed channel as claimed in claim 7, further comprising storing channel IDs including channel information of each of the one or more channels, the channel IDs being mapped in the one or more channels.

9. The method for providing the fixed channel as claimed in claim 8, wherein the deciding whether or not there is a change in the stored channels decides the channel change or non-change by comparing the channel ID of the changed channel with the channel IDs of the stored channels.

10. The method for providing the fixed channel as claimed in claim 7, 8 or 9 further comprising:
receiving a broadcasting signal corresponding to a channel selected by a user command among the stored channels; and
while the broadcasting signal corresponding to the selected channel is received, performing an auto search.

11. The method for providing the fixed channel as claimed in claim 7, 8 or 9 wherein the deciding whether or not there is a change in the stored channels decides the change or non-change of the stored channels by performing auto search in a standby mode.

12. A broadcasting receiving apparatus, comprising:
a storing unit (170, 370) which stores a mapping of one or more channel numbers to corresponding channel frequencies and channel identifiers respectively; and
a control unit (180, 390) configured to detect if a channel frequency or channel identifier corresponding to a stored channel number has been changed, search for the channel identifier mapped to the stored channel in the storing unit (170, 370), determine the new channel frequency corresponding to the searched channel identifier and remap the new channel frequency to the stored channel number in the storage unit (170, 370).

13. A method of storing channels, comprising:
storing a first mapping of one or more channels to corresponding channel frequencies and channel identifiers;
detecting a change in a channel frequency or channel identifier corresponding to a stored channel number;
searching for the channel identifier mapped to the stored channel according to the first mapping;
determining the new channel frequency of the searched channel identifier; and
storing a second mapping wherein the new channel frequency is mapped to the stored channel and the searched channel identifier.
